# EUROPÄISCHE PATENTSCHRIFT

(11) **EP 3 260 732 B1**
(45) Veröffentlichungstag und Bekanntmachung des Hinweises auf die Patenterteilung: **27.03.2019**
(21) Anmeldenummer: 16175909.7
(22) Anmeldetag: 23.06.2016
(51) Int. Cl.: F16F 15/027

(54) **PNEUMATISCHER AKTOR SOWIE VERFAHREN ZUM BETRIEB EINES AKTIVEN SCHWINGUNGSISOLATIONSSYSTEM**
PNEUMATIC ACTUATOR AND METHOD FOR OPERATING AN ACTIVE VIBRATION ISOLATING SYSTEM
ACTIONNEUR PNEUMATIQUE ET PROCEDE DE FONCTIONNEMENT D'UN SYSTEME ACTIF D'ISOLATION D'OSCILLATIONS

(43) Veröffentlichungstag der Anmeldung: 27.12.2017
(73) Patentinhaber: Integrated Dynamics Engineering GmbH, 65479 Raunheim (DE)
(72) Erfinder: Evers, Arndt, 65375 Oestrich-Winkel (DE); Hofmann, Frank, 61191 Rosbach (DE); Hartgers, Han, 55122 Mainz (DE); Scharf, Till, 63150 Heusenstamm (DE)
(74) Vertreter: Blumbach · Zinngrebe Patent- und Rechtsanwälte

(56) Entgegenhaltungen:
- WO-A1-2008/038433
- DE-C1- 4 324 595

## Beschreibung

### Gebiet der Erfindung

Die Erfindung betrifft einen pneumatischen Aktor, welcher insbesondere zur Verwendung in einem stationären Schwingungsisolationssystem ausgebildet ist.

Weiter betrifft die Erfindung ein Verfahren zum Betrieb eines aktiven Schwingungsisolationssystems sowie ein Schwingungsisolationssystem mit einem pneumatischen Aktor.

Die Erfindung betrifft insbesondere stationäre, also ortsfest, angeordnete Schwingungsisolationssysteme, auf welchen Lithographie- und/oder Metrologieanlagen zur Prozessierung von Halbleiterbauelementen schwingungsisoliert gelagert sind.

### Hintergrund der Erfindung

Stationäre Schwingungsisolationssysteme, wie sie insbesondere zur Aufnahme von Lithographie- oder Metrologiegeräten zur Prozessierung von Halbleitern verwendet werden, bestehen zumeist aus einem Tisch, welcher auf mehreren Isolatoren gelagert ist.

Aus der Praxis bekannt sind insbesondere aktive Schwingungsisolationssysteme, bei denen eine aktive Regelung vorhanden ist, die seismischen Schwingungen oder von der zu isolierenden Last (Maschinen) verursachten Schwingungen entgegenwirkt. So können über am Boden und/oder an der zu isolierenden Last angeordnete Sensoren Schwingungen gemessen werden. Die gewonnenen Messwerte werden von einer Regeleinrichtung dazu verwendet, aktiv Kompensationssignale zu erzeugen, über die Aktoren zur aktiven Schwingungsisolation angesteuert werden. In der Praxis werden zumeist in oder an einem pneumatischen oder mechanischen (z.B. Schraubenfeder) Isolator angeordnete Magnetaktoren verwendet, um Gegenkräfte zu erzeugen.

Mit der Größe der zu prozessierenden Halbleiterbauelemente steigt auch die Größe der hierfür verwendeten Anlagen. Hierdurch sind durch die Aktoren aufzubringende Reaktionskräfte immer höher, was die Verwendung von elektrisch angetriebenen Aktoren erschwert. Dies führt dazu, dass in einer Wirkrichtung mehrere, nach dem magnetischen Prinzip arbeitende Aktoren parallel geschaltet werden müssen. Dies ist aufwendig und aufgrund des knappen Bauraums im manchen Anwendungsfällen auch nicht möglich. Die Verwendung von Magnetaktoren wird des Weiteren durch deren immer vorhandene Wärmeabfuhr begrenzt.

Die Notwendigkeit der Ansteuerung von Magnetaktoren kann zwar durch die Einbindung einer pneumatischen Niveauregulierung des Schwingungsisolationssystems in die aktive Schwingungsisolation reduziert werden. Dies genügt jedoch nicht immer, um vorstehend genannte Nachteile zu beseitigen.

Ein mechanischer Schwingungsisolator mit einer Schraubenfeder ist in der Offenlegungsschrift EP 2 759 763 A2 (Integrated Dynamics Engineering GmbH) gezeigt
Die Offenlegungsschrift EP 2 998 611 A2 (Integrated Dynamics Engineering GmbH) zeigt einen Isolator mit einer Luftfeder, dessen Charakteristik über ein austauschbares Blattfederpaket anpassbar ist und welcher ein Biegependel aufweist, um eine Isolationswirkung in horizontaler Richtung bereitzustellen.

Aus der Praxis bekannte pneumatische Stellglieder, wie beispielsweise Balgzylinder, pneumatische Muskeln und pneumatische Zylinder, wirken aber zumeist nur in einer Richtung und sind aufgrund vorhandener Reibkräfte zwischen Zylinder und Kolben und/oder aufgrund quer zur eigentlichen Wirkrichtung vorhandener Kraftkomponenten für den Isolator eines gattungsbildenden stationären Schwingungsisolationssytems wenig geeignet.

Das Dokument DE 43 24 595 C1 zeigt einen Schwingungsmotor für einen Schüttelbock, der im Druckereibereich verwendet wird. Das Dokument WO 2008/038433 A1 zeugt einen Schwingungsdämpfer.

### Aufgabe der Erfindung

Der Erfindung liegt demgegenüber die Aufgabe zugrunde, die genannten Nachteile des Standes der Technik zu reduzieren.

Es ist insbesondere eine Aufgabe der Erfindung, einen pneumatischen Aktor bereitzustellen, welcher auch für stationäre aktive Schwingungsisolationssysteme geeignet ist.

### Zusammenfassung der Erfindung

Die Aufgabe der Erfindung wird bereits durch einen pneumatischen Aktor sowie durch ein Verfahren zum Betrieb eines aktiven Schwingungsisolationssystems nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft einen pneumatischen Aktor, also insbesondere einen Aktor, welcher mittels Luftdruck betrieben wird.

Der pneumatische Aktor ist insbesondere zur Verwendung in einem stationären Schwingungsisolationssystem ausgebildet, wie dieses zur schwingungsisolierten Lagerung von Maschinen und Anlagen zur Prozessierung von Halbleiterbauelementen verwendet wird.

Der pneumatische Aktor umfasst einen Arbeitsraum mit einem Kolben. In dem Arbeitsraum kann sich der Kolben bewegen und so eine Kraft in der axialen Bewegungsrichtung des Kolbens erzeugen.

Der Arbeitsraum wird durch den Kolben in eine erste und eine zweite Druckkammer aufgeteilt, so dass der Kolben von beiden Seiten mit Druck beaufschlagt werden kann, wodurch auf einfache Weise eine Kraft in zwei entgegengesetzten Richtungen erzeugt werden kann.

Um Reibkräfte sowie durch eine Bewegung des Kolbens verursachte Schwingungen zu minimieren, ist der Kolben durch einen Spalt von der Innenwand des Arbeitsraums beabstandet.

Der Kolben wird also nicht durch den Zylinder, welchen der Arbeitsraum ausbildet, geführt, sondern hat einen derart großen Abstand zur Innenwand des Arbeitsraums, dass der Kolben in normalen Betriebszuständen nicht an der Innenwand des Arbeitsraums anstößt.

Dennoch ist gemäß der Erfindung der Kolben nur in einer axialen Richtung, also in der Wirkrichtung des Kolbens, bewegbar, das heißt der pneumatische Aktor ist ausgebildet, um Kräfte in genau einer Raumrichtung zu erzeugen.

Dadurch, dass eine Verkippung oder Verschiebung des Kolbens quer zur Wirkrichtung verhindert wird, werden bei einer Ansteuerung des Aktors auftretende Kräfte quer zur gewünschten Wirkrichtung minimiert oder verhindert.

Gemäß der Erfindung ist der Kolben durch zumindest zwei voneinander beabstandete Blattfedern axial geführt.

Es ist insbesondere vorgesehen, dass eine Blattfeder in der ersten Druckkammer und eine weitere Blattfeder in der zweiten Druckkammer angeordnet ist.

Die Blattfedern stellen sicher, dass der Kolben nicht verkippt oder sich quer zur Wirkrichtung verschiebt. Vorzugsweise sind erste und zweite Druckkammer sowie die Blattfedern im Wesentlichen spiegelsymmetrisch ausgebildet, haben also jeweils in etwa die gleiche Form und gleiche Dimensionierung.

Als Blattfeder kann insbesondere eine Blattfeder mit einem Innenring und einem Außenring verwendet werden, wie sie in der EP 2 998 611 A1 beschrieben ist.

Vorzugsweise sind erste und zweite Druckkammer jeweils mit einer Membran verschlossen.

Die Membran überspannt zumindest den zwischen Kolben und Innenwand vorhandenen Spalt.

Bei einer bevorzugten Ausführungsform der Erfindung überspannt die Membran den Kolben.

Es ist insbesondere vorgesehen, eine Membran zu verwenden, welche am Gehäuse des Arbeitsraums befestigt wird, insbesondere vom Gehäuse des Arbeitsraums eingespannt wird und welche ansonsten den gesamten Arbeitsraum überspannt und damit bereits als solche die jeweilige Druckkammer verschließt.

So lässt sich kolbenseitig eine besonders leichte Abdichtung der Druckkammer bereitstellen.

Bei einer bevorzugten Ausführungsform der Erfindung ist der Kolben jeweils über ein in die Druckkammer ragendes Distanzstück mit der entsprechenden Blattfeder verbunden. Die Blattfeder kann sich so in radialer Richtung über eine große Fläche des Arbeitsraums erstrecken.

Das Distanzstück kann, wie es bei einer Ausführungsform der Erfindung vorgesehen ist, auch verwendet werden, um die Membran am Kolben zu fixieren.

Bei einer anderen Ausführungsform der Erfindung sind Kolben und Distanzstück einstückig ausgebildet.

Bei dem Distanzstück kann es sich insbesondere um einen mittigen Fortsatz des Kolbens handeln, welcher sich in axialer Richtung in die jeweilige Druckkammer erstreckt.

Bei einer bevorzugten Ausführungsform der Erfindung umfasst der Kolben zumindest einen aus einer Seitenwand des Arbeitsraums herausragenden Fortsatz.

Dieser Fortsatz kann insbesondere als umlaufender Ring ausgebildet sein.

Bei einer bevorzugten Ausführungsform der Erfindung umfasst der Kolben mehrere seitlich herausragende Fortsätze. Insbesondere umfasst der Kolben zumindest drei seitlich in horizontaler Richtung herausragende Fortsätze.

Der Fortsatz bzw. die Fortsätze dienen dazu, den Kolben mit der zu isolierenden Last oder mit der Basis (Boden) zu koppeln.

Vorzugsweise umfasst hierzu der pneumatische Aktor Mittel zum Hinzufügen einer zur axialen Richtung quer verlaufenden Isolation.

Der Aktor ist also quer zu seiner Wirkrichtung von der Basis oder von der zu isolierenden Last entkoppelt. Hierunter wird verstanden, dass die Steifigkeit des Aktors in dieser Raumrichtung geringer, insbesondere zumindest 10 Mal geringer, als die Steifigkeit in Wirkrichtung ist.

Die Kopplung kann, insbesondere um eine symmetrische Kraftbeaufschlagung des Kolbens zu erzielen, an zumindest drei um den Umfang des Kolbens verteilten Stellen erfolgen.

Anstelle eines Fortsatzes, welcher als umlaufender Ring ausgebildet ist, können daher auch mehrere einzelne Fortsätze verwendet werden, welche jeweils aus dem Gehäuse des Arbeitsraums herausstehen.

Um den Kolben mit der Basis oder der zu isolierenden Last zu koppeln, können insbesondere Biegestäbe, Knickpendel, Seile oder Drähte verwendet werden.

Vorzugsweise sind die Mittel zum Hinzufügen einer zur axialen Richtung quer verlaufenden Isolation außerhalb des Arbeitsraums des Kolbens angeordnet.

Es ist insbesondere vorgesehen, dass die Mittel, die eine Isolationswirkung quer zur Wirkrichtung des Kolbens haben, seitlich neben dem Arbeitsraum des Kolbens angeordnet sind.

Die Erfindung betrifft des Weiteren einen Isolator für ein Schwingungsisolationssystem, welcher zumindest zwei der vorstehend beschriebenen pneumatischen Aktoren umfasst, welche in unterschiedlicher Raumrichtung wirksam sind. Insbesondere ist vorgesehen, dass der Isolator einen vertikalen und einen horizontal wirksamen pneumatischen Aktor aufweist.

Der erfindungsgemäße Isolator ist insbesondere als pneumatischer oder als mechanischer Isolator, insbesondere als mechanischer Isolator mit einer Schraubenfeder, ausgebildet und umfasst neben einer zumindest in horizontaler Richtung wirksame Feder zwei pneumatische Aktoren.

Die Erfindung betrifft des Weiteren ein aktives Schwingungsisolationssystem. Dieses umfasst die vorstehend beschriebenen pneumatischen Aktoren. Insbesondere umfasst das Schwingungsisolationssystem Isolatoren, welche jeweils zumindest zwei pneumatische Aktoren aufweisen.

Es handelt sich insbesondere um ein aktives stationäres Schwingungsisolationssystem mit einer Regeleinrichtung, welche mit zumindest einem Sensor verbunden ist, der Schwingungen des Bodens und/oder der zu isolierenden Last erfasst und auf Basis der Sensorsignale über eine Feed-forward-Regelung Kompensationssignale erzeugt.

Weiter betrifft die Erfindung ein Verfahren zum Betrieb eines aktiven Schwingungsisolationssystems, insbesondere wie dies vorstehend beschrieben wurde.

Dabei werden pneumatische Aktoren, welche in zumindest einer Richtung wirksam sind, über eine Regeleinrichtung angesteuert.

Die Regeleinrichtung ist mit Ventilen zur Steuerung des Drucks in dem Arbeitsraum der pneumatischen Aktoren verbunden.

Die von den pneumatischen Aktoren ausgeübte Kraft und/oder der Druck in Druckkammern der pneumatischen Aktoren wird über einen Sensor gemessen, was von der Regeleinrichtung erfasst wird.

Um Kompensationssignale zu erzeugen, werden die pneumatischen Aktoren über die Regeleinrichtung angesteuert, indem diese über ein Ventil den Druck im Arbeitsraum des Aktors einstellt.

Der Druck wird dabei unter Berücksichtigung der nicht linearen Charakteristik des Fluids in den Druckkammern angesteuert.

Im Unterschied zu einem Hydraulikfluid ist Luft komprimierbar, was dazu führt, dass beispielsweise die Öffnungszeit eines Ventils, welches Luft in den Arbeitsraum des Aktors strömen lässt, nicht proportional zur daraus resultierenden Kraft ist.

Dies wird erfindungsgemäß über einen digitalen oder analogen Regelungsfilter kompensiert. Alternativ werden ein proportionales Schieberventil, ein proportionales Druckventil oder ein Schnell-Schaltventil genutzt.

Der für das Verfahren verwendete pneumatische Aktor erzeugt eine Kraft in zumindest einer Richtung. Vorzugsweise wird ein pneumatischer Aktor verwendet, wie er zuvor beschrieben wurde, also ein Aktor, welcher eine Kraft in zwei entgegengesetzten Richtungen erzeugen kann.

### Kurzbeschreibung der Zeichnungen

Der Gegenstand der Erfindung soll im Folgenden bezugnehmend auf ein schematisch dargestelltes Ausführungsbeispiel anhand der Zeichnungen Fig. 1 bis Fig. 8 näher erläutert werden.
Fig. 1 zeigt eine schematische Schnittansicht eines Ausführungsbeispiels eines erfindungsgemäßen pneumatischen Aktors.
Fig. 2 ist eine Seitenansicht des Aktors, in welcher nunmehr zusätzlich vorhandene Mittel zur Bereitstellung einer quer zur Wirkrichtung verlaufenden Isolation dargestellt sind.
Fig. 3 ist eine schematische Ansicht eines Schwingungsisolationssystems mit Isolatoren, welche erfindungsgemäße Aktoren umfassen.
Fig. 4 zeigt eine Schnittansicht eines Ausführungsbeispiels eines erfindungsgemäßen Aktors.
Fig. 5 und Fig. 6 sind Explosionsdarstellungen des Aktors.
Fig. 7 ist eine perspektivische Ansicht des Aktors, an welchem bereits Biegestäbe angebracht sind.
Fig. 8 ist eine perspektivische Ansicht eines erfindungsgemäßen Isolators, in welchem der in den Figuren Fig. 4 bis Fig. 8 dargestellte Aktor eingebaut ist.

### Detaillierte Beschreibung der Zeichnungen

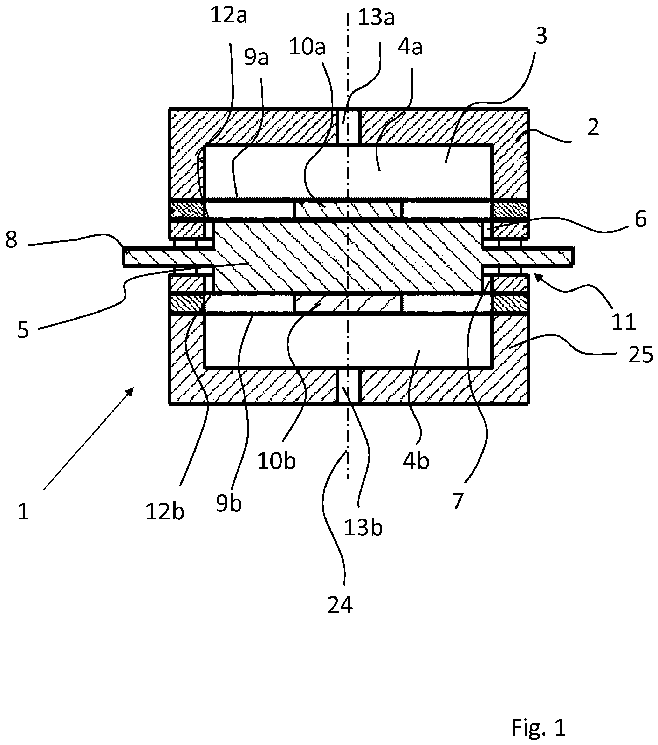

Fig. 1 ist eine schematische Schnittansicht eines Ausführungsbeispiels eines erfindungsgemäßen Aktors 1.

Der pneumatische Aktor 1 umfasst ein Gehäuse 2, welches einen Arbeitsraum 3 einschließt, in welchem sich der Kolben 5 bewegen kann. Der Arbeitsraum bildet ein Arbeitsvolumen aus, in welches Druckluft geleitet werden kann.

Der Arbeitsraum 3 ist durch den Kolben 5 in eine erste Druckkammer 4a und eine zweite Druckkammer 4b unterteilt.

Die Druckkammer 4a umfasst den pneumatischen Anschluss 13a und die Druckkammer 4b umfasst den pneumatischen Anschluss 13b.

Über die Anschlüsse 13a und 13b kann Druckluft in die ansonsten geschlossenen Druckkammern 4a und 4b eingeleitet werden.

So kann mittels des Kolbens 5 eine Kraft in axialer Richtung, also eine Kraft entlang der Achse 24, erzeugt werden.

Im Unterschied zu bekannten Pneumatikzylindern ist zwischen der Innenwand 7 Gehäuses 2 des Arbeitsraums 3 und dem Kolben 5 ein Spalt 6 vorhanden, was dazu führt, dass bei einer Bewegung des Kolbens 5 keine Reibkräfte auftreten. Der Spalt 6 ist mindestens 0,1, vorzugsweise mindestens 0,5 und besonders bevorzugt mindestens 1 mm breit.

Um die Druckkammern 4a und 4b zu verschließen, also um zu verhindern, dass Fluid durch den Spalt 6 ausströmt, ist jeweils eine elastische Membran 12a, 12b vorgesehen, welche zumindest den Spalt 6 überspannt.

In diesem Ausführungsbeispiel überspannt die Membran 12a, 12b den gesamten Kolben 5 und ist gleichzeitig mit dem Kolben 5 verbunden.

Weiter ist die Membran 12a, 12b jeweils randseitig in der Seitenwand 25 des Gehäuses 2 eingespannt.

Um den Kolben 5 in axialer Richtung zu führen, ist sowohl in der Druckkammer 4a, als auch in der Druckkammer 4b eine Blattfeder 9a, 9b vorgesehen, welche jeweils über das Distanzstück 10a und 10b mit dem Kolben 5 verbunden ist.

Die Blattfedern 9a und 9b sind ebenfalls an der Seitenwand 25 des Arbeitsraums 3 befestigt, insbesondere in der Seitenwand 25 eingespannt.

Vorzugsweise sind die Blattfedern 9a, 9b innerhalb der Druckkammer 4a bzw. 4b befestigt, um ansonsten nötige Dichtmittel zu vermeiden.

Die Blattfedern 9a und 9b verlaufen senkrecht zur Achse 24 und können insbesondere als Blattfeder mit einem Innenring und einem Außenring ausgebildet sein.

Die Distanzstücke 10a, 10b sind auf jeweils einer Seite des Kolbens 5 befestigt und dienen in diesem Ausführungsbeispiel zugleich der Befestigung der Membran 12a, 12b am Kolben 5.

In diesem Ausführungsbeispiel ist der pneumatische Aktor im Wesentlichen rotationssymmetrisch zur Achse 24, welche sich in Wirkrichtung mittig durch den pneumatischen Aktor 1 erstreckt, ausgebildet.

Weiter sind erste und zweite Druckkammer 4a, 4b nebst Blattfedern 9a, 9b und Membran 12a, 12b im Wesentlichen identisch aufgebaut. Die Blattfedern 9a und 9b sind hinsichtlich ihrer Form und Funktion gespiegelt verbaut.

Die Seitenwand 25 des Gehäuses 2 umfasst eine Öffnung 11, aus welcher ein senkrecht zur Achse 24 verlaufender Fortsatz 8 heraussteht.

Es versteht sich, dass der Fortsatz 8 in der Öffnung 11 derart viel Spiel hat, dass dieser beim Betrieb des pneumatischen Aktors 1 nicht an der Seitenwand 25 anstößt.

Der Fortsatz 8 ist in diesem Ausführungsbeispiel als umlaufender Ring ausgebildet. Der Fortsatz 8 kann Öffnungen aufweisen, durch die sich Bauteile erstrecken, über die die beiden Hälften des Gehäuses 2 verbunden sind (nicht dargestellt).

Der Fortsatz 8 dient der Ankopplung des Kolbens 5 an der Basis oder an der zu isolierenden Last.

Es versteht sich, dass statt eines umlaufenden Rings auch mehrere Fortsätze vorgesehen sein können, welche sich um den Umfang des pneumatischen Aktors 1 verteilen (nicht dargestellt).

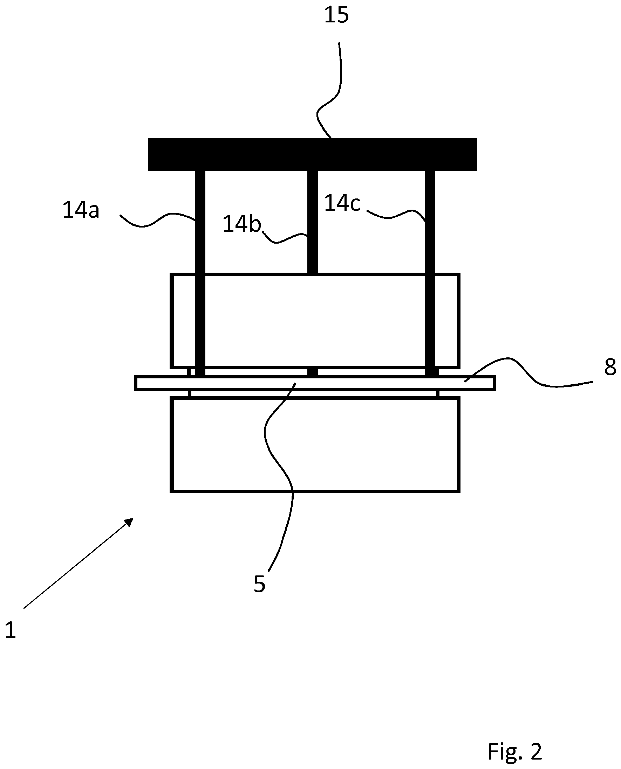

Fig. 2 zeigt in einer schematischen Seitenansicht den pneumatischen Aktor 1, wobei in dieser Ansicht auch die Bauteile dargestellt sind, welche den Kolben 5 mit der zu isolierenden Last 15 (oder der Basis) verbinden.

In diesem Ausführungsbeispiel sind an dem Fortsatz 8 drei Biegestäbe 14a bis 14c um den Umfang des Fortsatzes 8 gleichmäßig verteilt und mit der zu isolierenden Last 15 verbunden.

Durch die Biegestäbe 14a bis 14c ist eine Isolation quer zur Wirkachse des pneumatischen Aktors 1 vorhanden.

Die Biegestäbe 14a bis 14c haben eine hohe Steifigkeit in Wirkrichtung (Achse 24 in Fig. 1), geben bei einer quer hierzu verlaufenden Kraft aber nach und entkoppeln so Basis und zu isolierende Last quer zur Wirkrichtung des pneumatischen Aktors 1.

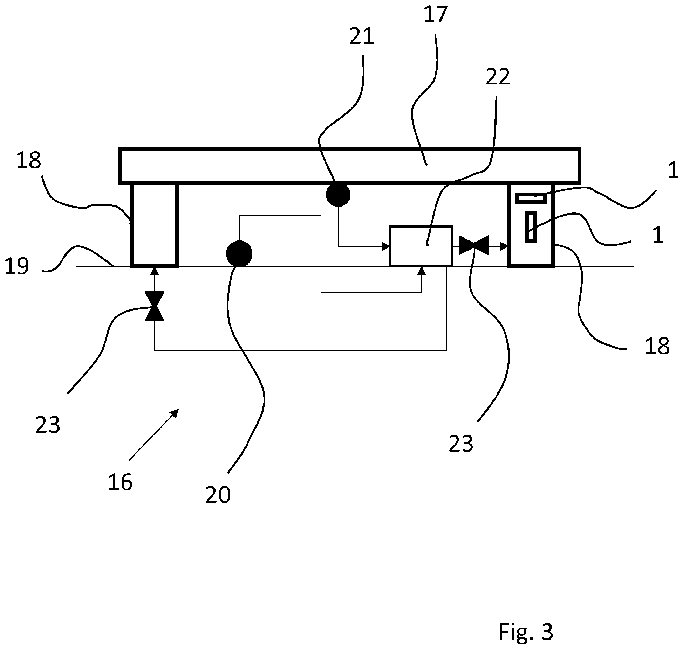

Fig. 3 ist eine schematische Ansicht eines Schwingungsisolationssystems 16.

Das Schwingungsisolationssystem 16 umfasst einen schwingungsisoliert gelagerten Tisch 17, auf welchem insbesondere Lithographie- und Metrologieanlagen zur Prozessierung von Halbleiterbauelementen (nicht dargestellt) angeordnet sein können.

Der Tisch 17 ruht auf mehreren Isolatoren 18, welche mit dem Boden 19 gekoppelt sind.

Die Isolatoren 18 können als pneumatische oder mechanische Federn ausgebildet sein.

Die Isolatoren 18 umfassen zumindest zwei der zuvor dargestellten pneumatischen Aktoren 1, wobei ein Aktor in horizontaler und ein Aktor in vertikaler Raumrichtung wirksam ist.

Es versteht sich, dass das Schwingungsisolationssystem noch weitere Aktoren, insbesondere Magnetaktoren auf Basis des Tauchspulenprinzips, umfassen kann.

In diesem Ausführungsbeispiel werden seismische Schwingungen über den Sensor 20 und Schwingungen der zu isolierenden LasL, also des Tisches 17 mit den darauf angeordneten Baugruppen, über den Sensor 21 erfasst.

Eine Regeleinrichtung 22 generiert auf Basis der Signale der Sensoren 21 und 20 Kompensationssignale, indem Ventile 23 angesteuert werden, über welche der Druck in den Druckkammern der pneumatischen Aktoren 1 geregelt wird.

Es versteht sich, dass für jeden Anschluss einer Druckkammer ein Ventil vorhanden ist, dass in diesem Ausführungsbeispiel aber nur schematisch jeweils ein Ventil 23 eingezeichnet ist.

Um zu berücksichtigen, dass Luft kompressibel ist, können die Aktoren 1 über eine Feed-forward-Regelung auf Basis des Drucks in den Druckkammern oder auf Basis einer mittels eines Sensors (nicht dargestellt) gemessenen Kraft angesteuert werden.

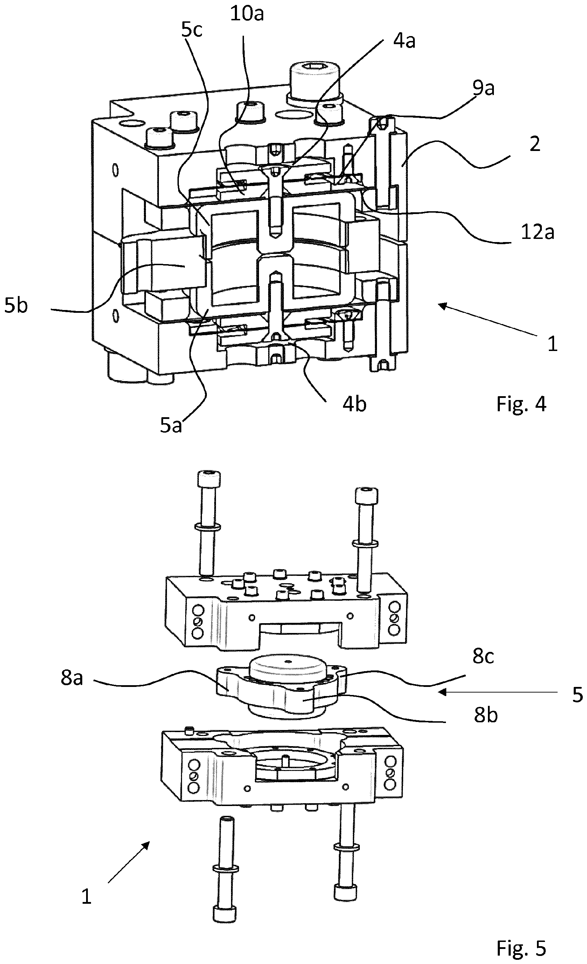

Bezugnehmend auf Fig. 4 bis Fig. 7 soll ein Ausführungsbeispiel eines erfindungsgemäßen Aktors näher erläutert werden.

Fig. 4 ist eine perspektivische, aufgeschnittene Ansicht eines pneumatischen Aktors 1.

In diesem Ausführungsbeispiel besteht der Kolben aus den drei Teilen 5a bis 5c.

Auch in diesem Ausführungsbeispiel teilt der Kolben, bestehend aus den Teilen 5a bis 5c, den Arbeitsraum in zwei Druckkammern 4a, 4b auf.

Das Distanzstück 10a klemmt die Blattfeder 9a und die Membran 12a an den Kolben.

Es versteht sich, dass die spiegelbildlich angeordnete untere Druckkammer entsprechend ausgebildet ist.

Fig. 5 ist eine Explosionsdarstellung des in Fig. 4 dargestellten Aktors.

Die beiden Teile des Gehäuses (2 in Fig. 4) sind nunmehr voneinander getrennt und es ist der Kolben 5, welcher aus drei Teilen besteht (5a bis 5c in Fig. 4), zu erkennen.

Zu erkennen ist, dass der Kolben 5 drei Fortsätze 8a bis 8c aufweist, welche seitlich nach außen ragen und welche um den Umfang des Kolbens 5 in diesem Ausführungsbeispiel um jeweils 120° verteilt sind.

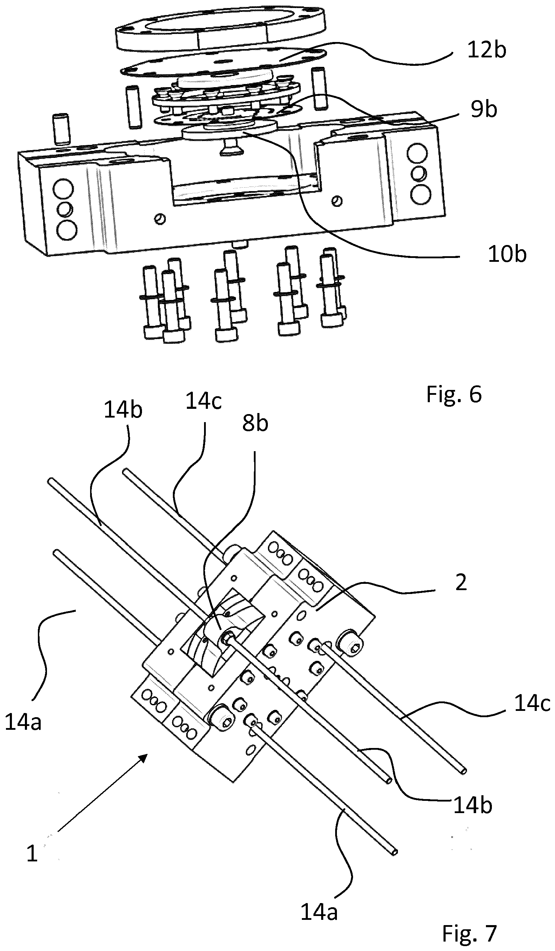

Fig. 6 ist eine weitere Explosionsdarstellung, bei der das obere Gehäuseteil sowie der Kolben ausgeblendet ist.

Zu erkennen ist hier insbesondere das Distanzstück 10b, mit welchem die Blattfeder 9b sowie die Membran 12b am Kolben befestigt wird.

Die Blattfeder 9b ist im Wesentlichen kreisförmig ausgebildet und umfasst einen Innenring und einen Außenring.

Fig. 7 zeigt den zuvor dargestellten Aktor 1, wobei nunmehr auf jeder Seite jeweils 3 Biegestäbe 14a bis 14c angebracht sind, die einer Isolation senkrecht zur Wirkrichtung des Aktors 1 dienen.

Zu erkennen ist, dass der Fortsatz 8b aus dem Gehäuse 2 des Aktors seitlich herausragt.

Die Fortsätze für die Biegestäbe 14a und 14c befinden sich im Inneren des Gehäuses. Demzufolge sind im Gehäuse zwei Bohrungen zur Durchführung der Biegestäbe 14a und 14c vorgesehen.

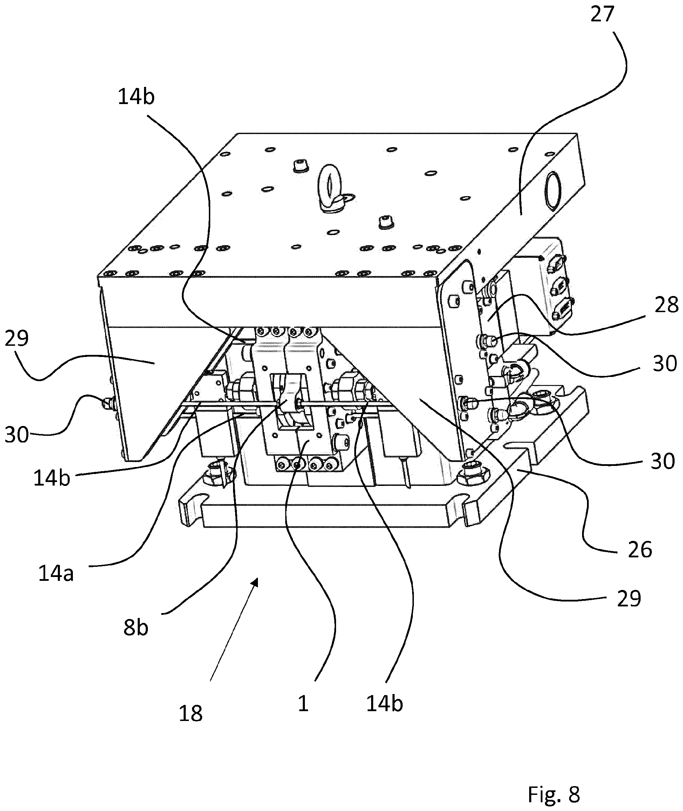

Fig. 8 ist eine perspektivische Ansicht auf einen Isolator 18, in welchem zur aktiven Schwingungsisolation der in den Figuren Fig. 4 bis Fig. 7 dargestellte Aktor 1 eingebaut ist.

Der hier dargestellte Aktor 1 dient zur Erzeugung von Kompensationssignalen in horizontaler Richtung.

Der Isolator 18 umfasst ein Gehäuse 28, in welchem sich eine vorzugsweise sowohl in vertikaler als auch in horizontaler Richtung wirksame Feder zur Isolation befindet. Die Feder ist vorzugsweise als pneumatische Feder ausgebildet (nicht zu sehen).

Das Gehäuse 28 ist mit einem Unterteil 26 verbunden, welches die Verbindung zum Boden bildet.

Das Oberteil 27 ruht schwingungsisoliert auf der Feder und dient der Kopplung der zu isolierenden Last.

Der Aktor 1 ist am Gehäuse 28 angebracht.

Das Oberteil 27 umfasst Aufnahmen 29, an welchen die Biegestäbe 14a bis 14b befestigt werden.

Über die Biegestäbe 14a bis 14c ist das Oberteil, also die schwingungsisoliert gelagerte Last, mit dem Aktor 1 verbunden.

Zu erkennen sind hier insbesondere die Biegestäbe 14b, welche mit dem Fortsatz 8b verbunden sind.

Die Biegestäbe 14a bis 14c werden über Schrauben 30 vorgespannt.

Im Betrieb des Aktors werden die Biegestäbe 14a bis 14c nur auf Zug belastet und entkoppeln den Aktor 1 in vertikaler Richtung von der schwingungsisoliert gelagerten Last.

Es versteht sich, dass der Isolator 18 vorzugsweise noch einen weiteren Aktor 1 umfasst, welcher in vertikaler Richtung wirksam ist (nicht zu sehen).

Durch die Erfindung konnte ein kompakter Aktor bereitgestellt werden, mit welchem sich hohe Kräfte erzeugen lassen und welcher insbesondere als Ersatz für einen Magnetaktor geeignet ist.

### Bezugszeichenliste

- 1: pneumatischer Aktor
- 2: Gehäuse
- 3: Arbeitsraum
- 4a, 4b: Druckkammer
- 5: Kolben
- 5a-5c: Teil
- 6: Spalt
- 7: Innenwand
- 8, 8a-8c: Fortsatz
- 9a, 9b: Blattfeder
- 10a, 10b: Distanzstück
- 11: Öffnung
- 12a, 12b: Membran
- 13a, 13b: Anschluss
- 14a-14c: Biegestab
- 15: Last
- 16: Schwingungsisolationssystem
- 17: Tisch
- 18: Isolator
- 19: Boden
- 20: Sensor
- 21: Sensor
- 22: Regeleinrichtung
- 23: Ventil
- 24: Achse
- 25: Seitenwand
- 26: Basis
- 27: Oberteil
- 28: Gehäuse
- 29: Aufnahme
- 30: Schraube
- 30: Schraube

## Patentansprüche

1. Pneumatischer Aktor (1), ausgebildet für ein stationäres Schwingungsisolationssystem (16), umfassend einen Arbeitsraum (3) mit einem Kolben (5), der den Arbeitsraum in eine erste (4a) und eine zweite (4b) Druckkammer aufteilt, wobei der Kolben (5) durch einen Spalt (6) von der Innenwand (7) des Arbeitsraums (3) beabstandet ist, wobei der Kolben (5) nur in einer axialen Richtung verschiebbar ist, wobei der Kolben (5) durch zumindest zwei voneinander beabstandete Blattfedern (9a, 9b) axial geführt ist.

2. Pneumatischer Aktor (1) nach dem vorstehenden Anspruch, **dadurch gekennzeichnet, dass** eine Blattfeder (9a) in der ersten Druckkammer (4a) und eine weitere Blattfeder ((9b) in der zweiten Druckkammer (4b) angeordnet ist.

3. Pneumatischer Aktor (1) nach einem der vorstehenden Ansprüche, **dadurch gekennzeichnet, dass** erste (4a) und die zweite Druckkammer (4b) jeweils mit einer Membran (12a, 12b) verschlossen ist.

4. Pneumatischer Aktor (1) nach dem vorstehenden Anspruch, **dadurch gekennzeichnet, dass** die Membran (12a, 12b) den Kolben (5) überspannt.

5. Pneumatischer Aktor (1) nach einem der vorstehenden Ansprüche, **dadurch gekennzeichnet, dass** der Kolben (5) über ein jeweils in die Druckkammer (4a, 4b) ragendes Distanzstück (10a, 10b) mit den Blattfedern (9a, 9b) verbunden ist.

6. Pneumatischer Aktor (1) nach einem der vorstehenden Ansprüche, **dadurch gekennzeichnet, dass** der Kolben (5) zumindest einen aus einer Seitenwand (25) des Arbeitsraums (3) herausragenden Fortsatz (8) aufweist.

7. Pneumatischer Aktor (1) nach einem der vorstehenden Ansprüche, **dadurch gekennzeichnet, dass** der Kolben (5) mehrere, insbesondere mindestens drei, seitlich herausragende Fortsätze (8) aufweist.

8. Pneumatischer Aktor (1) nach einem der vorstehenden Ansprüche, **dadurch gekennzeichnet, dass** der pneumatische Aktor (1) Mittel zum Hinzufügen einer zur axialen Richtung quer verlaufenden Isolation umfasst.

9. Pneumatischer Aktor (1) nach einem der vorstehenden Ansprüche, **dadurch gekennzeichnet, dass** der Kolben (5) über zumindest einen Biegestab (14a - 14c), ein Knickpendel, ein Seil oder einen Draht mit der zu isolierenden Last (15) oder einer Basis verbunden ist.

10. Pneumatischer Aktor (1) nach Anspruch 8, **dadurch gekennzeichnet, dass** die Mittel zum Hinzufügen einer zur axialen Richtung quer verlaufenden Isolation außerhalb des Arbeitsraums (3) angeordnet sind.

11. Pneumatischer Aktor (1) nach einem der beiden vorstehenden Ansprüche **dadurch gekennzeichnet, dass** der Kolben (5) über mehrere um den Umfang des Kolbens (5) herum verteilte Biegestäbe (14a - 14c), Knickpendel, Seile oder Drähte mit der zu isolierenden Last (15) oder einer Basis verbunden ist.

12. Isolator (18) für ein Schwingungsisolationssystem (16), umfassend zumindest zwei pneumatische Aktoren (1) nach einem der vorstehenden Ansprüche, wobei die zumindest zwei pneumatischen Aktoren (1) in unterschiedlicher Richtung wirksam sind.

13. Aktives Schwingungsisolationssystem (16), umfassend pneumatische Aktoren (1), insbesondere Isolatoren (18) mit pneumatischen Aktoren (1), nach einem der vorstehenden Ansprüche.

14. Verfahren zum Betrieb eines aktiven Schwingungsisolationssystems (16) nach dem vorstehenden Anspruch,
wobei pneumatische Aktoren (1), die in zumindest einer Richtung wirksam sind, über eine Regeleinrichtung (22), die mit einem Ventil (23) zur Steuerung des Drucks in einem Arbeitsraum (3) des pneumatischen Aktors verbunden sind, angesteuert werden,
wobei die von den pneumatischen Aktoren (1) ausgeübte Kraft und/oder der Druck in Druckkammern (4a, 4b) der pneumatischen Aktoren (1) gemessen wird,
und wobei die Regeleinrichtung (22) die pneumatischen Aktoren (1) unter Berücksichtigung der nicht linearen Charakteristik des Fluids in den Druckkammern (4a, 4b) ansteuert, indem eine Öffnungszeit des Ventils (23) nicht proportional zu der daraus resultierenden Kraft durch Kompensation über einen digitalen oder analogen Reglungsfilter oder indem ein proportionales Schieberventil, ein proportionales Druckventil oder ein Schnell-Schaltventil verwendet wird, gesteuert wird.

## Claims

1. A pneumatic actuator (1) configured for a stationary vibration isolation system (16), comprising a working space (3) with a piston (5) which divides the working space into a first (4a) and a second (4b) pressure chamber, wherein the piston (5) is spaced from the inner wall (7) of the working space (3) by a gap (6), wherein the piston (5) is displaceable only in an axial direction, wherein the piston (5) is axially guided by at least two spaced apart leaf springs (9a, 9b).

2. The pneumatic actuator (1) according to the preceding claim, **characterized in that** one leaf spring (9a) is disposed in the first pressure chamber (4a) and a further leaf spring (9b) in the second pressure chamber (4b) .

3. The pneumatic actuator (1) according to any one of the preceding claims, **characterized in that** each of the first (4a) and second (4b) pressure chambers is closed by a diaphragm (12a, 12b).

4. The pneumatic actuator (1) according to the preceding claim, **characterized in that** the diaphragm (12a, 12b) spans the piston (5).

5. The pneumatic actuator (1) according to any one of the preceding claims, **characterized in that** the piston (5) is connected to the leaf springs (9a, 9b) through a respective spacer piece (10a, 10b) projecting into the pressure chamber (4a, 4b).

6. The pneumatic actuator (1) according to any one of the preceding claims, **characterized in that** the piston (5) has at least one extension (8) projecting out of a lateral wall (25) of the working space (3).

7. The pneumatic actuator (1) according to any one of the preceding claims, **characterized in that** the piston (5) has a plurality of laterally projecting extensions (8), in particular at least three.

8. The pneumatic actuator (1) according to any one of the preceding claims, **characterized in that** the pneumatic actuator (1) comprises means for adding an isolation transversely to the axial direction.

9. The pneumatic actuator (1) according to any one of the preceding claims, **characterized in that** the piston (5) is connected to the load to be isolated (15) or to a base through at least one bending rod (14a - 14c), a buckling pendulum, a cord, or a wire.

10. The pneumatic actuator (1) according to claim 8, **characterized in that** said means for adding an isolation transversely to the axial direction are disposed outside of the working space (3).

11. The pneumatic actuator (1) according to any one of the two preceding claims, **characterized in that** the piston (5) is connected to the load to be isolated (15) or to a base through a plurality of bending rods (14a - 14c), buckling pendulums, cords, or wires which are distributed around the circumference of the piston (5).

12. An isolator (18) for a vibration isolation system (16), comprising at least two pneumatic actuators (1) according to any one of the preceding claims, wherein said at least two pneumatic actuators (1) are effective in different directions.

13. An active vibration isolation system (16), comprising pneumatic actuators (1), in particular isolators (18) with pneumatic actuators (1) according to any one of the preceding claims.

14. A method for operating an active vibration isolation system (16) according to the preceding claim,
wherein pneumatic actuators (1) which are effective in at least one direction are controlled by a control device (22) which is connected to a valve (23) for controlling the pressure in a working space (3) of the pneumatic actuator;
wherein the force exerted by the pneumatic actuators (1) and/or the pressure in the pressure chambers (4a, 4b) of the pneumatic actuators (1) is measured;
and wherein the control device (22) controls the pneumatic actuators (1) while taking into account the non-linear characteristics of the fluid in the pressure chambers (4a, 4b), by controlling an opening time of the valve (23) in non-proportional manner to the resulting force by compensation via a digital or analog control filter, or by using a proportional sliding valve, a proportional pressure valve, or a quick-switching valve.

## Revendications

1. Actionneur pneumatique (1), prévu pour un système d'isolation de vibrations fixe (16), comprenant un espace de travail (3) avec un piston (5) partageant l'espace de travail en une première (4a) et une deuxième (4b) chambre de pression, le piston (5) étant séparé par un interstice (6) de la paroi intérieure (7) de l'espace de travail (3), le piston (5) n'étant coulissant qu'en direction axiale, le piston (5) étant guidé axialement par au moins deux ressorts à lame (9a, 9b) espacés l'un de l'autre.

2. Actionneur pneumatique (1) selon la revendication précédente, **caractérisé en ce qu'**un ressort à lame (9a) est disposé dans la première chambre de pression (4a) et un autre ressort à lame (9b) est disposé dans la deuxième chambre de pression (4b).

3. Actionneur pneumatique (1) selon l'une des revendications précédentes, **caractérisé en ce que** la première (4a) et la deuxième chambre de pression (4b) sont fermées chacune par une membrane (12a, 12b).

4. Actionneur pneumatique (1) selon la revendication précédente, **caractérisé en ce que** la membrane (12a, 12b) couvre le piston (5).

5. Actionneur pneumatique (1) selon l'une des revendications précédentes, **caractérisé en ce que** le piston (5) est raccordé aux ressorts à lames (9a, 9b) par une pièce intercalaire (10a, 10b) en saillie dans chaque chambre de pression (4a, 4b).

6. Actionneur pneumatique (1) selon l'une des revendications précédentes, **caractérisé en ce que** le piston (5) présente au moins un prolongement (8) dépassant d'une paroi latérale (25) de l'espace de travail (3).

7. Actionneur pneumatique (1) selon l'une des revendications précédentes, **caractérisé en ce que** le piston (5) présente plusieurs, en particulier au moins trois, prolongements (8) dépassant latéralement.

8. Actionneur pneumatique (1) selon l'une des revendications précédentes, ledit actionneur pneumatique (1) étant **caractérisé en ce qu'**il comprend des moyens pour l'ajout d'une isolation s'étendant transversalement à la direction axiale.

9. Actionneur pneumatique (1) selon l'une des revendications précédentes, **caractérisé en ce que** le piston (5) est relié à la charge (15) à isoler ou à une base par au moins une barre de flexion (14a - 14c), un balancier déformable, un câble ou un fil métallique.

10. Actionneur pneumatique (1) selon la revendication 8, **caractérisé en ce que** les moyens pour l'ajout d'une isolation s'étendant transversalement à la direction axiale sont disposés extérieurement à l'espace de travail (3).

11. Actionneur pneumatique (1) selon l'une des deux revendications précédentes, **caractérisé en ce que** le piston (5) est relié à la charge (15) à isoler ou à une base par plusieurs barres de flexion (14a - 14c), balanciers déformables, câbles ou fils métalliques répartis sur toute la circonférence du piston (5).

12. Isolateur (18) pour un système d'isolation de vibrations (16), comprenant au moins deux actionneurs pneumatiques (1) selon l'une des revendications précédentes, lesdits au moins deux actionneurs pneumatiques (1) agissant dans des directions différentes.

13. Système actif d'isolation de vibrations (16), comprenant des actionneurs pneumatiques (1), en particulier des isolateurs (18) avec des actionneurs pneumatiques (1) selon l'une des revendications précédentes.

14. Procédé de fonctionnement d'un système actif d'isolation de vibrations (16) selon la revendication précédente, des actionneurs pneumatiques (1) agissant dans au moins une direction étant commandés par un dispositif de régulation (22) relié par une vanne (23) pour la commande de pression dans un espace de travail (3) de l'actionneur pneumatique, la force exercée par les actionneurs pneumatiques (1) et/ou la pression dans les chambres de pression (4a, 4b) des actionneurs pneumatiques (1) étant mesurées, et le dispositif de régulation (22) commandant les actionneurs pneumatiques (1) en tenant compte de la caractéristique non linéaire du fluide dans les chambres de pression (4a, 4b), un temps d'ouverture de la vanne (23), non proportionnel à la force résultante étant commandé par compensation au moyen d'un filtre de régulation numérique ou analogique, ou une vanne à tiroir proportionnelle, une vanne de pression proportionnelle ou une vanne à commande rapide étant utilisées.
